(19) Europäisches Patentamt
European Patent Office
Office européen des brevets

(11) EP 2 326 156 A1

(12) EUROPEAN PATENT APPLICATION
published in accordance with Art. 153(4) EPC

(43) Date of publication:
25.05.2011 Bulletin 2011/21

(51) Int Cl.:
*H05K 3/46* (2006.01)

(21) Application number: 08810295.9

(22) Date of filing: 09.09.2008

(86) International application number:
PCT/JP2008/066240

(87) International publication number:
WO 2010/029611 (18.03.2010 Gazette 2010/11)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(71) Applicant: Fujitsu Limited
Kawasaki-shi, Kanagawa 211-8588 (JP)

(72) Inventor: SUGANE, Mitsuhiko
Kawasaki-shi
Kanagawa 211-8588 (JP)

(74) Representative: Holz, Ulrike
Haseltine Lake LLP
Lincoln House, 5th Floor
300 High Holborn
London WC1V 7JH (GB)

(54) **MULTILAYER FLEXIBLE PRINTED WIRING BOARD AND ELECTRONIC DEVICE**

(57) The present invention relates to a multilayer flexible printed circuit board used for high-speed transmission and an electronic apparatus, and having a structure in which one set of lamination includes: a core material made of an insulating material and having bendability; a solid layer provided on one surface of the core material, the solid layer being made of an electrically conductive material to form a ground plane; and a wiring layer provided on the other surface of the core material, the wiring layer being made of an electrically conductive material and impedance-controlled, wherein a plurality of sets of lamination are laminated via an insulation layer.

FIG.7

**Description**

FIELD

The present invention relates to multilayer flexible wiring boards and electronic apparatuses and, more particularly, to a multilayer flexible wiring board and an electronic apparatus used for high-speed transmission.

BACKGROUND

Generally, a printed wiring board having electronic parts and electronic circuits mounted thereon is incorporated in an electronic apparatus such as a network system, a server system equipment, etc. A function of an electronic apparatus of this type has been diversified, and, in association with the diversification, a number of parts mounted on a printed wiring board tends to increase. On the other hand, standardization is attempted in the electronic apparatus of this type, and, the size of the printed wiring board is also standardized in many cases.

Therefore, in the printed wiring board having a standardized predetermined size, if a number of parts is increased, it may be difficult to mount all of electronic parts to be mounted on the printed wiring board. Thus, in recent years, it is suggested to prepare a printed wiring board (hereinafter, referred to as a sub-board) having a shape smaller than a printed wiring board (hereinafter, referred to as a main board) having a standardized predetermined size in order to laminate the sub-board onto the main board and connect the boards to each other by a connector. Thereby, it is possible to substantially increase an area for mounting electronic parts so that many parts can be mounted on the standardized board having the predetermined size (refer to Patent Document 1).

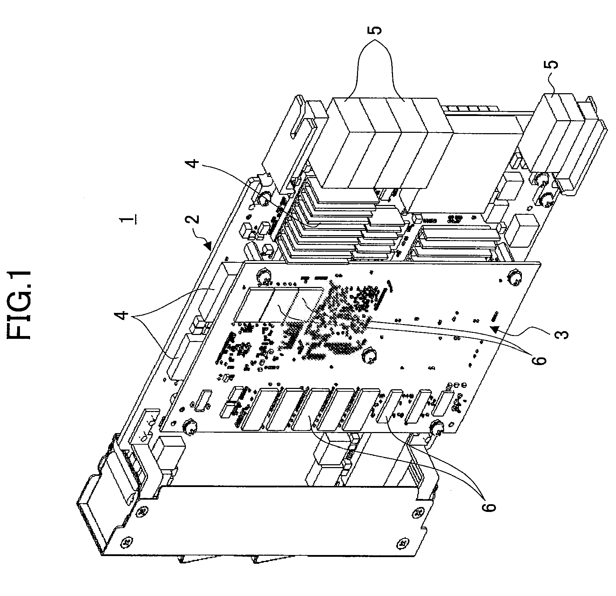

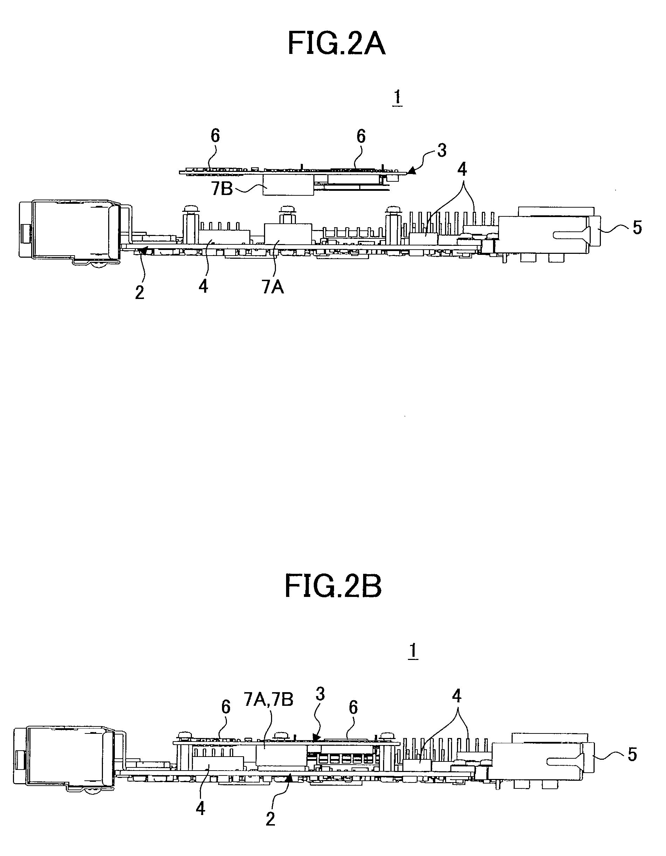

An example of an electronic apparatus having a printed wiring board of this kind is illustrated in FIG. 1, FIG. 2A and FIG. 2B. In each figure, a plug-in unit is indicated as an example of the electronic apparatus. The plug-in unit 1 includes a primary substrate 2 (hereinafter, referred to as a main board 2) formed by a printed wiring board. Many electronic parts 4 are mounted on the main board 2 in a very dense state.

The size of the main board 2 is defined by specifications, and the main board 2 cannot be changed into a size larger than that defined by the specifications. However, with multifunctionalization of the plug-in unit 1, a number of parts has been increasing, and it has become a condition that all of the parts cannot be mounted on the main board 2.

Thus, conventionally, an auxiliary substrate 3 (hereinafter, referred to as a sub-board 3) is provided separately from the main board 2 in order to mount electronic parts 6, which have not been mounted onto the main board 2, onto the sub-board 3 and laminate the sub-board 3 onto the main board 2 and electrically connect the main board 2 and sub-board 3 to each other. FIG. 2A illustrates a state before the sub-board 3 is mounted onto the main board 2, and FIG. 2B illustrates a state where the sub-board 3 has been mounted on the main board 2.

Conventionally, the electric connection between the main board 2 and the sub-board 3 is achieved by providing a board connection connector 7A on the main board 2 and also providing a board connection connector 7B on the sub-board 3 and fitting the board connection connectors 7A and 7B to each other (for example, refer to Patent Document 1 mentioned below).

However, in the method of using the board connection connectors 7A and 7B to connect the main board 2 and the sub-board 3, there is a limitation in a number of wires provided between the main board 2 and the sub-board 3 because a number of wire connections between the main board 2 and the sub-board 3 is determined by a number of connector pins.

The board connection connectors 7A and 7B are arranged on the main board and the sub-board 3, respectively. On the other hand, if the number of pins of the board connection connectors 7A and 7B is increased, there may be a problem in that a number of electronic parts, which can be mounted on each of the boards 2 and 3, is limited.

Further, in the case where the board connection connectors 7A and 7B are used, it is difficult to perform an impedance control because the electrical connection is achieved by a contact between plug pins and contacts.

In order to solve the problems, it is considered to use a micro strip using a flexible cable. In such a case, there is suggested a structure in which a middle conductor is sandwiched by insulation layers so that a conductive foil (a solid layer forming a ground plane) is formed on a side of each insulation layer opposite to the middle conductor, that is, an outer surface of the flexible cable (for example, refer to Patent Document 2).

Patent Document 1: Japanese Laid-Open Patent Application No. 11-220237
Patent Document 2: Japanese Laid-Open Patent Application No. 2008-117846

DISCLOSURE OF THE INVENTION

PROBLEM(S) TO BE SOLVED BY THE INVENTION

However, because the conductor is made of metal, the conductor has a lower flexibility than a resin used for the insulation layers, and, thus, a micro strip having a ground plane simply formed on an outer side thereof has a low flexibility.

MEANS TO SOLVE THE PROBLEM(S)

It is a general object of the present invention to provide an improved and useful multilayer flexible wiring board and an electronic apparatus in which the above-mentioned problems of the conventional art are eliminated.

In order to achieve the object, according to the present invention, there is formed a multilayer flexible printed circuit board having bendability, wherein one set of lamination includes: a core material made of an insulating material and having bendability; a solid layer provided on one surface of said core material, the solid layer being made of an electrically conductive material to form a ground plane; and a wiring layer provided on the other surface of said core material, the wiring layer being made of an electrically conductive material having a controlled impedance, wherein a plurality of sets of said lamination are laminated via an insulation layer.

Additionally, it can be achieved by an electronic apparatus comprising: a first rigid board; a second rigid board; and a multilayer flexible printed circuit board having bendability to connect said first rigid board and said second rigid board, wherein said multilayer flexible printed circuit board has a configuration in which a plurality of sets of lamination are laminated via an insulation layer, each set of said lamination including: a core material made of an insulating material and having bendability; a solid layer provided on one surface of said core material, the solid layer being made of an electrically conductive material to form a ground plane; and a wiring layer provided on the other surface of said core material, the wiring layer being made of an electrically conductive material having a controlled impedance.

EFFECT OF THE INVENTION

According to the present invention, by making a multilayer structure, the ground plane of a single layer can be thinner as compared to that of a case where a ground plane layer (a solid layer) is formed by a single layer of the conductive foil, flexibility can be acquired as compared to the conventional structure.

BRIEF DESCRIPTION OF DRAWINGS

FIG. 1 is a perspective view of an electronic apparatus which is a conventional example;
FIG. 2A is an exploded side view of the electronic apparatus which is a conventional example;
FIG. 2B is a side view of the electronic apparatus which is a conventional example;
FIG. 3A is a side view of an electronic apparatus according to an embodiment of the present invention;
FIG. 3B is a plan view of the electronic apparatus according to the embodiment of the present invention;
FIG. 4 is a plan view illustrating a state where a main board and a sub-board are connected by a multilayer flexible wiring board according to the embodiment of the present invention;
FIG. 5 is a perspective view of a shelf equipped with the electronic apparatus according to the embodiment of the present invention;
FIG. 6 is an enlarged cross-sectional view of connecting positions between the multilayer flexible wiring board according to the embodiment of the present invention and each of the main board and the sub-board;
FIG. 7 is a cross-sectional view of the multilayer flexible wiring board according to the embodiment of the present invention;
FIG. 8 is an exploded view of the multilayer flexible wiring board according to the embodiment of the present invention; and
FIG. 9 is a model diagram of a microstrip line.

EXPLANATION OF REFERENCE NUMERALS

10                multilayer flexible wiring board

| 11 | plug-in unit |
| 12 | main board |
| 13 | sub-board |
| 15 | external connection connector |
| 20 | rack |
| 21 | shelf |
| 23 | first through hole |
| 24 | second through hole |
| 25 | third through hole |
| 26 | fourth through hole |
| 28, 29 | contact pin |
| 34a, 34b | through hole wiring layer |
| 35a, 35b, 35c | prepreg |
| 36a, 36b, 36c | core material |
| 37a, 37b, 37c | solid layer |
| 38a, 38b | wiring layer 0 |
| 40 | first lamination |
| 41 | second lamination |
| 42 | ground plane lamination |

BEST MODE FOR CARRYING OUT THE INVENTION

A description will be given below, with reference to the drawings, of an embodiment of the present invention.

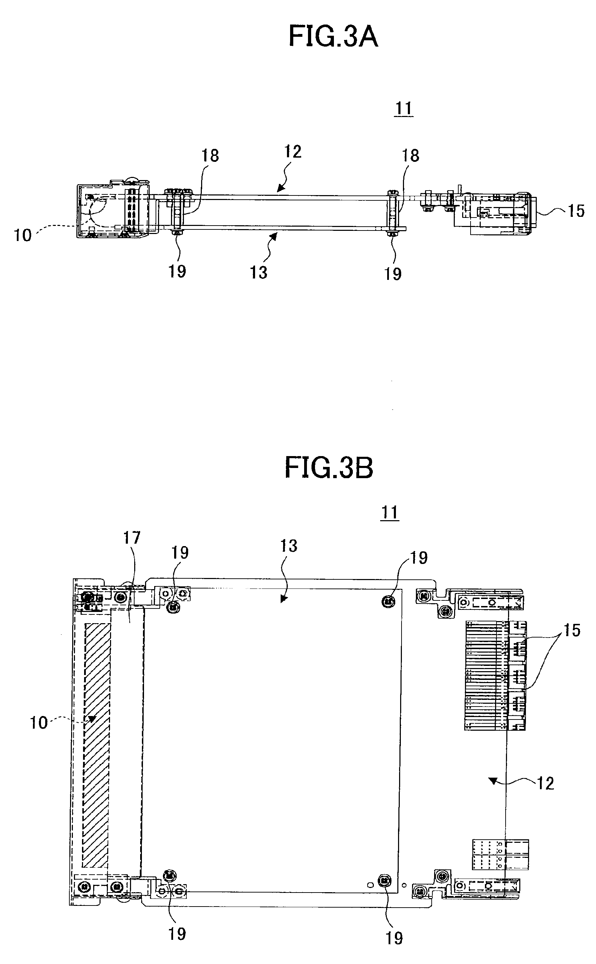

FIG. 3A and FIG. 3B illustrate an electronic device according to an embodiment of the present invention. In the present embodiment, a plug-in unit 11 is mentioned as an example of an electronic apparatus. The Plug-in unit 11 is attached to a network system or a server system apparatus.

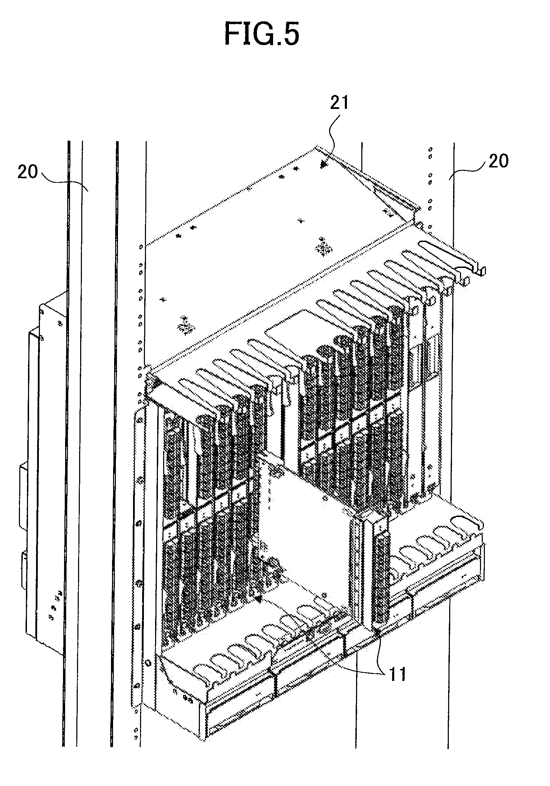

FIG. 5 illustrates a state where a network system apparatus is equipped with the plug-in unit 11. The network system apparatus is provided with a rack 20, and a plurality of shelves 21 are arranged in the rack 20 (for the sake of convenience, only one shelf is illustrated in FIG. 5). The plug-in unit 11 is attached to and detached from the shelf 21.

Generally, as illustrated in FIG. 3A and FIG. 3B, the plug-in unit 11 includes a primary substrate 12 (hereinafter, referred to as a main board 12) formed by a printed wiring board. Many electronic parts (not illustrated in the figure) are mounted on the main board 12 with high density.

As illustrated in FIG. 5, the plug-in unit 11 is attached to and detached from the shelf 21, and a size thereof is specified by a standard. Because the main board 12 has the largest shape among the structural elements of the plug-in unit 11, the shape of the plug-in unit 11 is determined by the main board 12. Therefore, the main board 12 cannot be formed in a shape larger than the size specified by the standard.

However, with multifunctionalization of the plug-in unit 11, a number of parts of the plug-in unit 11 has been increased, and it has become difficult to mount all of parts onto the main board 12 of the size specified by the standard. Thus, the plug-in unit 11 according to the present embodiment is also provided with an auxiliary substrate 13 (hereinafter, referred to as a sub-board 13) separately from the main board 12. Thus, electronic parts, which cannot be mounted on the main board 12, are mounted on the sub-board 13, and a structure in which the sub-board 13 is stacked on the main board 12 is adopted.

The main board 12 and the sub-board 13 are printed circuit boards as mentioned above. Specifically, each of the boards 12 and 13 has a structure in which a plurality of layers are laminated, in each of the layers, a copper wiring pattern is printed on an insulation layer formed of a glass-epoxy. Thus, each of the boards 12 and 13 is hard and made into a rigid board having small bendability and flexibility.

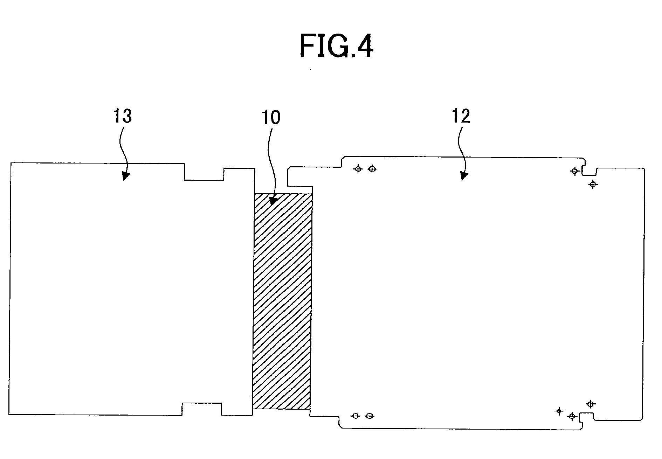

In the present embodiment, the main board 12 and the sub-board 13 are electrically connected using a multilayer flexible printed wiring board 10. FIG. 4 is a plan view illustrating a state where the multilayer flexible printed wiring board 10, the main board 12 and the sub-board 13 are developed. As illustrated in FIG. 4, one side (the right side in the figure) of the multilayer flexible printed wiring board 10 is connected to the main board 12, and the other side (the left side in the figure) is connected to the sub-board 13. The connection between the multilayer flexible printed wiring board 10 and the main board 12 and the electrical connection between the multilayer flexible printed wiring board 10 and the sub-board 13 are achieved by a connection structure using through holes 23 through 26 and connection pins 28 and 29, as mentioned later.

Moreover, in order to arrange the sub-board 13 on the main board 12 in a stacked state, the multilayer flexible printed wiring board 10 is bent in a generally U-shape. Because the multilayer flexible printed wiring board 10 has bendability, it can be easily bent in a U-shape.

As mentioned above, by bending the multilayer flexible printed wiring board 10 in the U-shape, the sub-board 13 is set in a state where it is stacked (overlapped) on the main board 12, as illustrated in FIG. 3A. In this state, columnar members 18 are arranged between the main board 12 and the sub-board 13 so as to fix the boards 12 and 13 to each other by using screws 19.

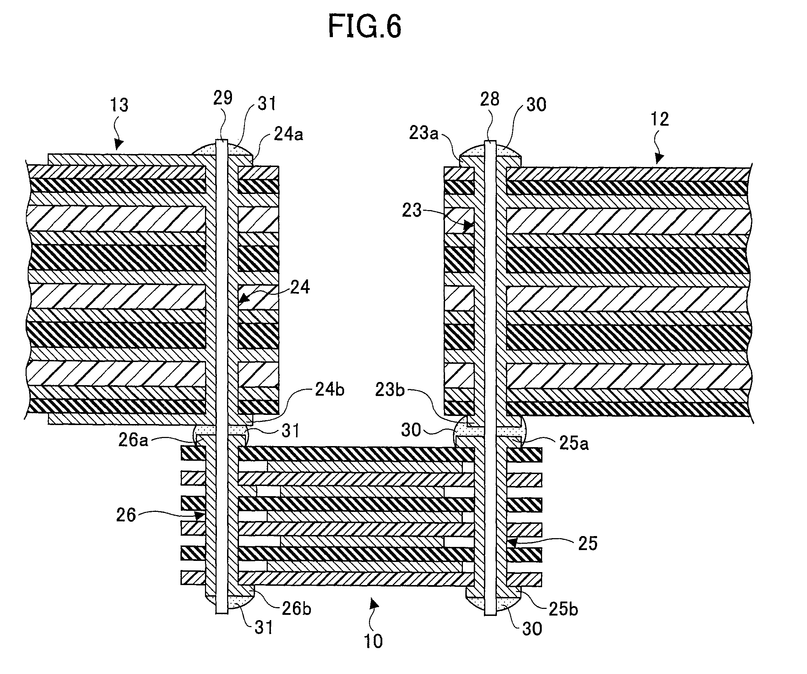

Hereinafter, a description is given in detail, with reference to FIG. 6 through FIG. 8, of the structure of the multilayer flexible printed wiring board 10 and the connection structure between the multilayer flexible printed wiring board 10 and each of the boards 12 and 13. In FIG. 6 through FIG. 8, specific parts are enlarged for the sake of convenience for explanation and illustration.

FIG. 6 is an enlarged view of connection portions between the multilayer flexible printed wiring board 10 and the main board 12 and between the multilayer flexible printed wiring board 10 and the sub-board 13. As illustrated in FIG. 6, a plurality of first through holes 23 are formed in a part near the edge of the main board 12, and also a plurality of second through holes 24 are formed near an edge of the sub-board 13.

The first through holes 23 are configured to be electrically connected to a predetermined inner-layer wiring inside the main board 12 by forming penetrating holes at predetermined positions near the edge of the main board 12 and copper-plating the inner surfaces of the penetrating holes. Additionally, land portions 23a are formed on the front surface of the main board 12, and the land portions 23a are integrally connected to the upper edges of the first through holes 23, respectively. Further, land portions 23b are formed on the back surface of the main board 12, and the land portions 23b are integrally connected to the lower edges of the first through holes 23, respectively.

Similarly, the second through holes 24 are configured to be electrically connected to a predetermined inner-layer wiring inside the sub-board 13 by forming penetrating holes at predetermined positions near the edge of the sub-board 13 and copper-plating the inner surfaces of the penetrating holes. Additionally, land portions 24a are formed on the front surface of the sub-board 13, and the land portions 24a are integrally connected to the upper edges of the second through holes 24, respectively. Further, land portions 24b are formed on the back surface of the sub-board 13, and the land portions 24b are integrally connected to the lower edges of the second through holes 24, respectively.

The multilayer flexible printed wiring board 10 has a multilayer structure in which a plurality of laminations 40 and 41 and the like are laminated (a specific structure will be explained in detail later). Third through holes 25 and fourth through holes 26 are formed in the part near both edges of the multilayer flexible printed wiring board 10. The positions of forming the third through holes 25 are set to correspond to the positions of the first through holes 23 mentioned above, and the positions of forming the fourth through holes 26 are set to correspond to the positions of the second through holes 24.

Each of the through holes 23 and 24 is formed by a manufacturing method substantially the same as the through holes 23 and 24 mentioned above. That is, the third and fourth through holes 25 and 26 are configured to be electrically connected to a predetermined inner-layer wiring inside the multilayer flexible printed wiring board 10 by forming penetrating holes at predetermined positions near both edges of the multilayer flexible printed wiring board 10 and copper-plating the inner surfaces of the penetrating holes. The formation of the penetrating holes can be carried out by drilling, and, thereby, the penetrating holes can be easily formed.

In order to connect the multilayer flexible printed wiring board 10 and the main board 12 to each other, positioning of the first through holes 23 and the third through holes 25 is performed first. Thereby, the center axes of the first through holes 23 are aligned with the center axes of the third through holes 25, respectively, and, thus, the first through holes 23 and the third through holes 25 are set in a coaxially aligned state.

In this state, connection pins 28 are inserted into the first through holes 23 and the third through holes 25, respectively. As for the connection pin 28, a metallic material (for example, a copper alloy) having an electric conductivity and a predetermined elasticity is selected. In the state where the connection pin 28 is inserted into the first and third through holes 23 and 25, one end of the connection pin 28 (an upper end part in FIG. 6) protrudes from the land portion 23a, and the other end of the connection pin 28 (a lower end part in FIG. 6) protrudes from the land portion 25b.

The land portion 23a and the connection pin 28 are fixed to each other by soldering, and the land portion 25b and the connection pin 28 are fixed to each other by soldering. Thereby, the multilayer flexible printed wiring board 10 and the main board 12 are connected electrically with each other. Because the connection pin 28 penetrates through the multilayer flexible printed wiring board 10 and the main board 12, the mechanical strength of the multilayer flexible printed wiring board 10 and the main board 12 can be raised as compared to a joining method of simple soldering.

Similarly, in order to connect the multilayer flexible printed wiring board 10 and the sub-board 13 to each other, positioning of the second through holes 24 and the fourth through holes 26 is performed first. Thereby, the center axes of the second through holes 24 are aligned with the center axes of the fourth through holes 26, respectively, and, thus, the second through holes 24 and the fourth through holes 26 are set in a coaxially aligned state.

In this state, connection pins 29 are inserted into the second through holes 24 and the fourth through holes 26, respectively. As for the connection pin 29, it is desirable to use a metallic material (for example, a copper alloy) having an electric conductivity and a predetermined elasticity. In the state where the connection pin 29 is inserted into the second and fourth through holes 24 and 26, one end of the connection pin 29 (an upper end part in FIG. 6) protrudes from the land portion 24a, and the other end of the connection pin 29 (a lower end part in FIG. 6) protrudes from the land portion 26b.

The land portion 24a and the connection pin 29 are fixed to each other by soldering, and the land portion 26b and the connection pin 29 are fixed to each other by soldering. Thereby, the multilayer flexible printed wiring board 10 and the sub-board 13 are connected electrically with each other. Because the connection pin 29 penetrates through the multilayer flexible printed wiring board 10 and the sub-board 13, the mechanical strength of the multilayer flexible printed wiring board 10 and the sub-board 13 can be raised as compared to a joining method of simple soldering.

Thus, in the present embodiment, because the connection pins 28 and 29 are used, instead of simple soldering, to join the multilayer flexible printed wiring board 10 and the main board 12 to each other and multilayer flexible printed wiring board 10 and the sub-board 13 to each other, it can be attempt to improve the electrical connection and the mechanical strength. Thereby, even if the multilayer flexible printed wiring board 10 is bent with respect to the main board 12 and the sub-board 13, which are rigid boards, there may be no connection defects or damages such as a crack generated at the joining positions between the first through holes 23 and the third through holes 25 and the joining position between the second through holes 24 and the fourth through holes 26. Thus, there is no situation happens where the reliability of the plug-in unit 11 is deteriorated even if the multilayer flexible printed wiring board 10 is used for the connection between the main board 12 and the sub-board 13.

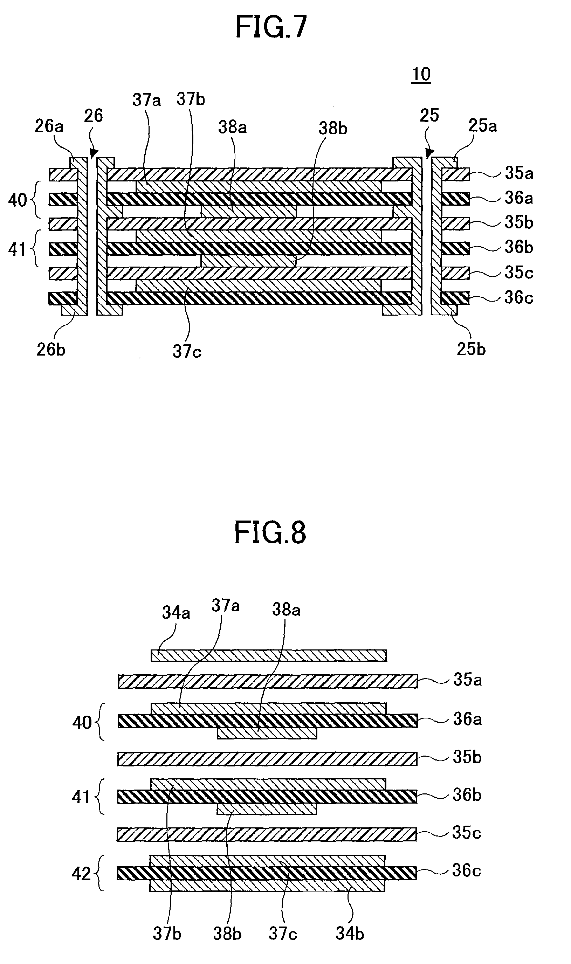

FIG. 7 and FIG. 8 illustrate a specific structure of the multilayer flexible printed wiring board 10. FIG. 7 is a cross-sectional view of the multilayer flexible printed wiring board 10, and FIG. 8 is an exploded view of the multilayer flexible printed wiring board 10.

The multilayer flexible printed wiring board 10 is formed by laminating, from the top layer, a through hole wiring layer 34a, a prepreg 35a, a first lamination 40, a prepreg 35b, a second lamination 41, a prepreg 35c, a solid layer 37c, a core material 36c, and a through hole wiring layer 34b.

The though hole wiring layer 34a and the through hole wiring layer 34b provided as an uppermost layer and a lowermost layer are, for example, copper films having a thickness of 12 $\mu$m. The though hole wiring layers 34a and 34b are made into the land portions 25a, 25b, 26a and 26b by being subjected to a patterning process according to an etching method.

The prepregs 35a through 35c are formed by impregnating an uncured thermosetting resin (for example, epoxy resin) into a reinforcing material such as a glass cloth. In the present embodiment, the thickness of the prepregs 35a through 35c is set to be equal to or larger than 45 $\mu$m and equal to or smaller than 55 $\mu$m. Although a generally used prepreg has a thickness equal to or larger than 65 $\mu$m, the prepregs 35a through 35c used in the present embodiment have a thickness as small as 45 $\mu$m or larger and 55 $\mu$m or smaller, thereby giving bendability to the prepregs 35a through 35c.

Here, the minimum of the thickness of the prepregs 35a through 35c is set to be equal to or larger than 45 $\mu$m because if the prepregs 35a through 35c are thinner than that, the prepregs 35a through 35c cannot provide the function as a reinforcing material. Additionally, the maximum of the thickness of the prepregs 35a through 35c is set to be equal to or smaller than 55 $\mu$m because if the prepregs 35a through 35c are thicker than that, desired bendability cannot be achieved. The prepregs 35a through 35c correspond to insulation layers recited in the claims.

The first and second laminations 40 and 41 have a substantially identical structure. The first lamination 40 is constituted by a core material 36a, a solid layer 37a and a wiring layer 38a. The second lamination 41 is constituted by a core material 36b, a solid layer 37b and a wiring layer 38b. A ground plane lamination 42 positioned at the lowermost part in the figure is constituted by the core material 36c, the solid layer 37c and the through hole wiring layer 34b.

Each of the laminations 40 through 42 is a so-called copper-clad lamination plate, and has a structure in which copper foils are provided to both surfaces of the core materials 36a through 36c serving as reinforcing materials, and the solid layers 37a through 37c, the wiring layers 38a and 38b and the through hole wiring layer 34b are formed by patterning the copper foils. The core materials 36a through 36c are formed by impregnating an epoxy resin into a glass cloth.

The core materials 36a through 36c are insulating materials to provide a function of retaining the solid layers 37a through 37c, the through hole wiring layer 34b and the wiring layers 38a and 38b. The core materials 36a and 36b are interposed between the solid layer 37a and the wiring layer 38a and between the solid layer 37b and the wiring layer 38b, respectively, to serve as dielectric materials.

In the present embodiment, the thickness of the core materials 36a through 36c is set to be equal to or larger than 45 $\mu$m and equal to or smaller than 55 $\mu$m. Similar to the above-mentioned prepregs, a generally used core material of a copper-clad lamination plate has a thickness equal to or larger than 65 $\mu$m. However, in the present embodiment, bedability is given by using a thin material having a thickness equal to or larger than 45 $\mu$m and equal to or smaller than 55 $\mu$m as the core materials 36a through 36c.

Here, the minimum of the thickness of the core materials 36a through 36c is set to be equal to or larger than 45 $\mu$m because if the core materials 36a through 36c are thinner than that, the core materials 36a through 36c cannot provide a function to retain the solid layers 37a through 37c, the through hole wiring layer 34b and the wiring layers 38a and 38b. Additionally, the maximum of the thickness of the core materials 36a through 36c is set to be equal to or smaller

than 55 μm because if the core materials 36a through 36c are thicker than that, desired bendability cannot be achieved.

The solid layers 37a through 37c and the wiring layers 38a and 38b are formed by patterning a copper film in a predetermined shape, and a thickness of each is set to be about 12 μm.

The solid layers 37a through 37c are formed on the core materials 36a through 36c, respectively, in each figure. The solid layers 37a through 37c are connected to the ground wirings of the main board 12 and the sub-board 13 through the through holes 25 and 26. Thus, the solid layers 37a through 37c serve as ground planes.

On the other hand, the wiring layers 38a and 38b are formed on lower surfaces of the core materials 36a and 36b in each figure. The wiring layers 38a and 38b are connected with signal wirings of the main board 12 and the sub-board 13 through the through holes 25 and 26. Therefore, wiring layers 38a and 38b serve as signal wirings. In addition, as mentioned above, the though hole wiring layer 34b is made into the land portions 25b and 26b by being subjected to patterning.

In the present embodiment, the multilayer flexible printed wiring board 10 is applied to the plug-in unit 11. Therefore, because a high-speed signal flows in the wiring layers 38a and 38b, it is required to perform an accurate impedance control in order to perform a good signal transmission. In the present embodiment, a microstrip line is formed by the wiring layers 38a and 38b and the solid layers 37a through 37c by laminating the laminations 40 through 42.

That is, the wiring layer 38a is retained by being sandwiched between the solid layers 37a and 37b, which serve as ground planes, via the insulation layers (the core material 36a and the prepreg 35b). Similarly, the wiring layer 38b is retained by being sandwiched between the solid layers 37b and 37c, which serve as ground planes, via the insulation layers (the core material 36b and the prepreg 35c).

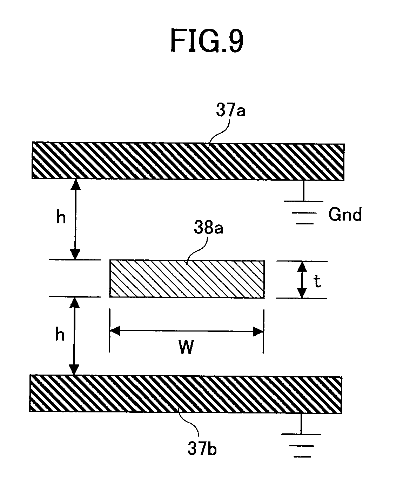

Moreover, in the present embodiment, the characteristic impedance of each of the wiring layers 38a and 38b is controlled to 50 Ω. A description is given, with reference to FIG. 9, of a specific method of controlling the characteristic impedance of each of the wiring layers 38a and 38b to 50 Ω. FIG. 9 is a model diagram of the microstrip line. Here, a description will be given of the wiring layer 38a as an example.

It is assumed that the thickness (h) of the core material 36a (insulating material) interposed between the solid layer 37a and the wiring layer 38a and the thickness (h) of the prepreg 35b (insulating material) interposed between the wiring layer 38a and the solid layer 37b are 50 μm (h=50 μm). Additionally, it is assumed that the pattern width W of the wiring layer 38a is 50 μm (W=50 μm). Moreover, it is assumed that the dielectric constant (εr) of the core material 36a and the prepreg 35b is 3.4. Further, the thickness (t) of the wiring layer 38a is controlled to be 12 μm according to an operation by a mathematical expression (formula 1) mentioned below.

The impedance of the model illustrated in FIG. 9 is obtained by substituting the above numeric values in the following formula to acquire an impedance Z0.

(formula 1)

$$Z_0 = \frac{60}{\sqrt{\varepsilon r}} \times \ln\left(\frac{1.9 \times (2 \times h + t)}{0.8 \times W + t}\right)$$

The value of the impedance Zo is calculated as 50.67 Ω by substituting the above-mentioned numerical values in the formula 1. By performing the same setting with respect to the wiring layer 38b, the characteristic impedance of each of the wiring layers 38a and 38b of the multilayer flexible printed wiring board 10 can be controlled to about 50 Ω. Thus, even if the multilayer flexible printed wiring board 10 is applied to the plug-in unit 11, which performs a high-speed transmission, a reliable signal transmission can be performed while reducing a transmission loss.

Although the preferred embodiment has been described in detail, the present invention is not limited to the above-mentioned specific embodiment, and various variations and modifications may be made without departing from a scope of the present invention recited in the claims.

For example, although the example in which the impedance of each of the wiring layers 38a and 38b is controlled to 50 Ω was explained in the above-mentioned embodiment, the impedance value is not limited to this and is controllable to an arbitrary value. Moreover, the thickness and width of the wiring layers 38a and 38b and the solid layers 37a through 37c, which form the multilayer flexible printed wiring board 10, may be changed, if necessary, in response to a desired impedance value.

Moreover, although the plug-in unit 11 was described as an example of an electronic apparatus to which the multilayer flexible printed wiring board 10 is applicable, it can be applied, of course, to other electronic apparatuses performing a high-speed transmission.

**Claims**

1. A multilayer flexible printed circuit board having bendability, wherein one set of lamination includes:

   a core material made of an insulating material and having bendability;
   a solid layer provided on one surface of said core material, the solid layer being made of an electrically conductive material to form a ground plane; and
   a wiring layer provided on the other surface of said core material, the wiring layer being made of an electrically conductive material having a controlled impedance,
   wherein a plurality of sets of said lamination are laminated via an insulation layer.

2. The multilayer flexible printed circuit board according to claim 1, wherein said lamination forms a microstrip line.

3. The multilayer flexible printed circuit board according to claim 1, wherein said core material is formed of an epoxy resin impregnated glass cloth.

4. The multilayer flexible printed circuit board according to claim 3, wherein a thickness of said core material is equal to or larger than 45 $\mu$m and equal to or smaller than 55 $\mu$m.

5. The multilayer flexible printed circuit board according to claim 1, wherein said wiring layer is impedance controlled to have a characteristic impedance of 50 Q.

6. The multilayer flexible printed circuit board according to claim 1, wherein a through hole is formed to connect said wiring layer and said solid layer.

7. The multilayer flexible printed circuit board according to claim 1, wherein said insulation layer is a prepreg.

8. An electronic apparatus comprising:

   a first rigid board;
   a second rigid board; and
   a multilayer flexible printed circuit board having bendability to connect said first rigid board and said second rigid board,
   wherein said multilayer flexible printed circuit board has a configuration in which a plurality of sets of lamination are laminated via an insulation layer, each set of said lamination including:

   a core material made of an insulating material and having bendability;
   a solid layer provided on one surface of said core material, the solid layer being made of an electrically conductive material to form a ground plane; and
   a wiring layer provided on the other surface of said core material, the wiring layer being made of an electrically conductive material having a controlled impedance.

9. The electronic apparatus according to claim 8, wherein said first rigid board has a first through hole; said second rigid board has a second through hole; said multilayer flexible printed circuit board has third and fourth through holes; and said first rigid board and said second rigid board are connected with each other through said flexible printed circuit board by said first through hole and said third through hole being connected to each other and said second though hole and said fourth through hole being connected to each other.

10. The electronic apparatus as claimed in claim 8, wherein said lamination forms a microstrip line.

11. The electronic apparatus as claimed in claim 8, wherein said core material is formed of an epoxy resin impregnated glass cloth.

12. The electronic apparatus as claimed in claim 11, wherein a thickness of said core material is equal to or larger than 45 $\mu$m and equal to or smaller than 55 $\mu$m.

13. The electronic apparatus as claimed in claim 8, wherein said wiring layer is impedance controlled to have a characteristic impedance of 50 $\Omega$.

**14.** The electronic apparatus as claimed in claim 8, wherein said insulation layer is a prepreg.

# FIG.1

EP 2 326 156 A1

# FIG.2A

# FIG.2B

# FIG.3A

# FIG.3B

# FIG.4

# FIG.5

FIG.6

# FIG.7

# FIG.8

# FIG.9

37a

38a

h

t

h

W

Gnd

37b

EP 2 326 156 A1

INTERNATIONAL SEARCH REPORT

International application No.

PCT/JP2008/066240

A. CLASSIFICATION OF SUBJECT MATTER
*H05K3/46*(2006.01)i

According to International Patent Classification (IPC) or to both national classification and IPC

B. FIELDS SEARCHED

Minimum documentation searched (classification system followed by classification symbols)
H05K3/46

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2000-269612 A (Sony Corp.), 29 September, 2000 (29.09.00), (Family: none) | 1-14 |
| Y | JP 7-50499 A (Fuji Xerox Co., Ltd.), 21 February, 1995 (21.02.95), Fig. 3 (Family: none) | 1-14 |
| Y | JP 6-216531 A (Ibiden Co., Ltd.), 05 August, 1994 (05.08.94), Par. No. [0012] (Family: none) | 3,4,11,12 |

☒ Further documents are listed in the continuation of Box C.      ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 December, 2008 (02.12.08) | 09 December, 2008 (09.12.08) |

| Name and mailing address of the ISA/ Japanese Patent Office | Authorized officer |
|---|---|
| Facsimile No. | Telephone No. |

Form PCT/ISA/210 (second sheet) (April 2007)

18

**INTERNATIONAL SEARCH REPORT**

| International application No. |
| --- |
| PCT/JP2008/066240 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 4-313300 A  (Sumitomo Electric Industries, Ltd.), 05 November, 1992 (05.11.92), Fig. 1 (Family: none) | 6 |
| Y | JP 2007-129153 A  (CMK Corp.), 24 May, 2007 (24.05.07), Par. No. [0009] (Family: none) | 7,14 |
| Y | Microfilm of the specification and drawings annexed to the request of Japanese Utility Model Application No. 37387/1989(Laid-open No. 129762/1990) (Anritsu Corp.), 25 October, 1990 (25.10.90), (Family: none) | 9 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11220237 A
- JP 2008117846 A